(19) Europäisches Patentamt
European Patent Office
Office européen des brevets

(11) Veröffentlichungsnummer: **0 006 124**
**B1**

(12) # EUROPÄISCHE PATENTSCHRIFT

(45) Veröffentlichungstag der Patentschrift: **22.12.82**

(51) Int. Cl.³: **G 03 F 7/10**, G 03 C 1/68

(21) Anmeldenummer: **79101409.5**

(22) Anmeldetag: **09.05.79**

(54) **Photopolymerisierbares Gemisch und lichtempfindliches Schichtübertragungsmaterial.**

(30) Priorität: **20.05.78 DE 2822189**

(43) Veröffentlichungstag der Anmeldung: **09.01.80 Patentblatt 80/1**

(45) Bekanntmachung des Hinweises auf die Patenterteilung: **22.12.82 Patentblatt 82/51**

(84) Benannte Vertragsstaaten: **BE CH DE FR GB IT NL SE**

(56) Entgegenhaltungen:
**DE-A-2 064 079**
**DE-A-2 300 371**
**DE-A-2 301 175**
**DE-A-2 404 239**
**GB-A- 850 453**
**US-A-3 951 657**

**DERWENT JAPANESE PATENTS REPORT, Vol. 74, Nr. 4, 26. Februar 1974 London, G. B. Teil 6, Seite 2, Spalte 2, Abschnitt 1.**

(73) Patentinhaber: **HOECHST AKTIENGESELLSCHAFT, Postfach 80 03 20, D-6230 Frankfurt/Main 80 (DE)**

(72) Erfinder: **Faust, Raimund Josef Dr. Ing. Dipl.-Chem., Adolf-Todt-Strasse 5, D-6200 Wiesbaden (DE)**

**EP 0 006 124 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

# Photopolymerisierbares Gemisch und lichtempfindliches Schichtübertragungsmaterial

Die Erfindung betrifft ein photopolymerisierbares Gemisch, das polymere Bindemittel, polymerisierbare Verbindungen und Photoinitiatoren enthält.

Derartige Gemische werden in der Reproduktionstechnik zur Herstellung von Druckplatten, Photoresists, d.h. Ätz- und Galvanoreservagen, und – ggf. farbigen – Reliefbildern verwendet.

Eine besondere Gruppe derartiger Gemische, die zur Photoresistherstellung dienen, wird als trockene photopolymerisierbare Schicht auf einem temporären Schichtträger aus einer transparenten flexiblen Kunststoffolie verwendet, wobei die Schicht unter Druck und Erwärmen auf einen bildmässig zu modifizierenden Träger aus Metall, z.B. eine Kupferplatte, laminiert, dort belichtet und zum Photoresist entwickelt wird. Die Schichten sollen bevorzugt die Eigenschaft haben, sich mit wässrigen, normalerweise wässrigalkalischen Entwicklerlösungen entwickeln zu lassen. Derartige Materialien und Verarbeitungsverfahren sind z.B. in der DE-AS 15 22 515 und den DE-OS 20 64 079 und 23 61 041 beschrieben.

Besonders die in den genannten Offenlegunsschriften beschriebenen Schichten zeigen bei wässrig-alkalischer Entwicklung eine gute Haftung auf dem Träger, insbesondere auf Kupfer, und eine gute Resistenz gegenüber Ätzlösungen und galvanischen Bädern.

Die hierfür erforderlichen, in wässrig-alkalischen Lösungen löslichen, mindestens aber quellbaren Bindemittel haben häufig den Nachteil, der belichteten Schicht eine gewisse Sprödigkeit zu verleihen. Das gilt insbesondere für solche Bindemittel, die wegen ihres Gehalts an Monomereinheiten, die dem Polymerisat eine höhere Glastemperatur verleihen, zur Vermeidung des Kaltflusses der unbelichteten Schicht besonders bevorzugt werden. Derartige Bindemittel sind z.B. in der US-PS 3 930 865 beschrieben.

Auch Monomere mit mehr als zwei polymerisierbaren Gruppen im Molekül, die wegen der hohen Vernetzungsdichte ihrer Belichtungsprodukte an sich besonders vorteilhaft sind, führen in der Regel zu Belichtunsprodukten, die relativ spröde sind, insbesondere wenn die Belichtung über das optimale Mass hinaus ausgedehnt wird.

Als Monomere oder polymerisierbare Verbindungen, die mit diesen Bindemitteln gut verträglich sind und andere für die Photoresisttechnik vorteilhafte Eigenschaften haben, haben sich besonders bestimmte Verbindungen mit Urethangruppen im Molekül bewährt. Derartige polymerisierbare Verbindungen sind in den oben genannten DE-OS beschrieben. Die Verbindungen der DE-OS 20 64 079, die stets zwei Urethangruppen im Molekül enthalten, ergeben infolge ihrer grösseren Zahl an Acrylestergruppen oder ihres relativ niedrigen Molekulargewichts eine hohe Vernetzungsdichte und damit Schichten, die nach der Belichtung zur Versprödung neigen. Diejenigen Vertreter, die ein höheres Molekulargewicht haben, ergeben wiederum Schichten, die zu geringerer Lichtempfindlichkeit und schlechterer Entwicklerresistenz neigen.

Die Verbindungen der DE-OS 23 61 041, die Biuretgruppen enthalten, weisen ebenfalls eine Tendenz zur Bildung relativ spröder Belichtungsprodukte auf. Die dort weiterhin beschriebenen Verbindungen mit vier Urethangruppen und einer Polyäthergruppe im Molekül sind wiederum den genannten Verbindungen mit zwei Urethangruppen noch recht ähnlich.

Man kann generell sagen, dass photopolymerisierbare Schichten, deren Kaltfluss im unbelichteten Zustand genügend klein ist, und die nach der Belichtung eine gute Haftung am Trägermetall, eine gute Entwicklerresistenz und Beständigkeit gegen Ätzlösungen und galvanische Bäder aufweisen, verhältnismässig spröde Belichtungsprodukte bilden. Das gilt besonders bei Überbelichtungen, d.h. es verbleibt für die Verarbeitung derartiger Schichten in der Regel nur ein sehr geringer Belichtungsspielraum, wenn man eine optimale Kombination von Eigenschaften erreichen will. Ein weiteres Verspröden kann schliesslich auch beim Lagern oder Handhaben der Produkte bei Tageslicht eintreten.

Durch die erhöhte Sprödigkeit der belichteten und auch der unbelichteten Photoresistschicht treten bei der Weiterverarbeitung, z.B. der Herstellung gedruckter Schaltungen, erhebliche Schwierigkeiten auf. Diese Schwierigkeiten bestehen darin, dass beim Beschneiden der mit dem Trockenresist kaschierten Kupferleiterplatten die spröde Resistschicht zur Bildung von Flittern neigt, die eine erhebliche Verschmutzung und Störung bei der Weiterverarbeitung zur Folge haben können. Zum anderen brechen die spröden Resistüberhänge beim Ätzen in den üblichen Sprühätzmaschinen leicht ab, oder es kommt zum Abplatzen feinerer Details der Photomasken in ungünstigen Galvanobädern, insbesondere bei Goldbädern, bei denen die Stromausbeute relativ gering ist (z.B. 45% bis herab zu 25%). Hierbei verursacht der entstehende Wasserstoff leicht ein Abplatzen von spröden Resistmasken.

Die hier beschriebenen Probleme sind zwar für die genannte Kombination von Schichtbestandteilen und Verarbeitungsbedingungen noch nirgends deutlich aufgezeigt worden. Man hat sich aber schon grundsätzlich mit dem Problem der Sprödigkeit von photopolymerisierbaren Schichten beschäftigt und zu seiner Lösung den Zusatz von Weichmachern empfohlen. So werden in der DE-AS 23 27 513, Spalte 14, als Weichmacher für bestimmte Typen photopolymerisierbarer Schichten Dibutylphthalat und andere Ester aromatischer und aliphatischer Dicarbonsäuren, Glykolester, Polyglykole, Alkyl- und Arylphosphate, bestimmte Sulfonamide und andere Verbindungen genannt. Diese und andere ähnliche Weichmacher werden auch in der US-PS 3 192 194, Spalte 4, und in der DE-AS 23 37 645, Spalte 12, genannt.

Alle hieraus bekannten Weichmacher haben in alkalisch entwickelbaren photopolymerisierbaren Schichten der oben bezeichneten Art bestimmte Nachteile. Viele sind mit den erforderlichen alkalilöslichen Bindemitteln nicht verträglich und schwitzen bei der Lagerung aus der unbelichteten oder aus der belichteten Schicht aus. Andere haben zwar eine gute Weichmacherwirkung und sind gut verträglich, ergeben aber Schichten mit zu hohem Kaltfluss in unbelichtetem Zustand. Andere wiederum setzen die Entwicklerresistenz der belichteten Schichtteile, deren Beständigkeit gegen galvanische Bäder oder deren Haftung auf dem metallischen Träger zu stark herab.

Aus den DE-OS 23 61 986 und 24 04 239 ist es ferner bekannt, polymerisierbaren Urethanen bzw. Polyurethanen bestimmte, ähnlich aufgebaute gesättigte Urethanverbindungen zuzusetzen und die Gemische durch Ultraviolettbestrahlung zu härten. Dabei sollen weichere, geschmeidigere Lichthärtungsprodukte entstehen. Die Gemische werden zur Herstellung von härtbaren Lacküberzügen oder zur Herstellung von Druckplatten verwendet. Im letzteren Fall ist ausser den genannten Bestandteilen kein polymeres Bindemittel, insbesondere kein alkalilösliches Bindemittel zugegen. Die Entwicklung erfolgt demgemäss mit organischen Lösungsmitteln. Die Herstellung von festen, mit wässrig-alkalischen Lösungen entwickelbaren Schichten ist mit den in diesen Druckschriften im einzelnen beschriebenen Verbindungen nicht möglich. Insbesondere lassen sich damit keine Schichten herstellen, die bei ausreichender Entwickler- und Galvanoresistenz der Belichtungsprodukte keinen Kaltfluss im unbelichteten Zustand aufweisen.

Aufgabe der Erfindung war es, ein photopolymerisierbares Gemisch vorzuschlagen, das feste, flexible, mit wässrigalkalischen Lösungen entwickelbare Schichten mit hoher Lichtempfindlichkeit und geringem Kaltfluss ergibt, deren Belichtungsprodukte gut auf Metallen, insbesondere Kupfer haften, eine hohe Resistenz gegenüber wässrigalkalischen Entwicklerlösungen sowie sauren Ätzlösungen und galvanischen Bädern aufweisen und auch bei beträchtlicher Überbelichtung noch flexibel bleiben.

Gegenstand der Erfindung ist ein photopolymerisierbares Gemisch, das ein polymeres, in wässrig-alkalischen Lösungen lösliches oder quellbares Bindemittel, einen Photoinitiator und eine zur Additionspolymerisation befähigte Verbindung mit mindestens zwei endständigen Acryl- oder Methacrylsäureestergruppen und einem Siedepunkt oberhalb 100° C enthält.

Das erfindungsgemässe Gemisch ist dadurch gekennzeichnet, dass es zusätzlich ein Polyurethan der Formel I

$$\begin{array}{l} Y\text{–}(NHCOO\text{–}X\text{–}CONH\text{–}Y\text{–})_nNHCOO\text{–}Z\text{–}R_1 \qquad (I) \\ | \\ NH \\ | \\ COO\text{–}Z\text{–}R_1 \end{array}$$

enthält, worin

X eine der Gruppen

$$\begin{array}{l} (\text{–}CH_2\text{–}\underset{\displaystyle R_2}{\underset{|}{CH}}\text{–}O)_m\text{–} \end{array}$$

$$(\text{–}CH_2\text{–}\underset{\displaystyle R_2}{\underset{|}{CH}}\text{–}S\text{–})_{m-1}CH_2\underset{\displaystyle R_2}{\underset{|}{CH}}\text{–}O\text{–} ,$$

$-C_kH_{2k}-O-$ und

$-C_rH_{2r-2}-O-$

Y ein gesättigter aliphatischer oder cycloaliphatischer Rest mit 2 bis 12 Kohlenstoffatomen,

Z $(\text{–}CH_2\text{–}\underset{\displaystyle R_3}{\underset{|}{CH}}\text{–}O)_p$

$R_1$ $R_4$ oder CONH-$R_4$,

$R_2$ und $R_3$ Wasserstoffatome oder Methylgruppen,

$R_4$ ein gesättigter aliphatischer Rest mit 1 bis 20 Kohlenstoffatomen,

n Null oder eine Zahl von 1 bis 15,

m eine Zahl von 2 bis 4,

p Null oder eine Zahl von 1 bis 4,

k eine Zahl von 2 bis 12,

r eine Zahl von 4 bis 12 und

n + p eine Zahl von 1 bis 19

ist, wobei $R_1$ $R_4$ bedeutet, wenn p=0 ist, und $R_1$ CONH-$R_4$ bedeutet, wenn n=0 ist.

Die erfindungsgemässen Gemische enthalten im allgemeinen 5 bis 40 Gew.-%, vorzugsweise 10 bis 35 Gew.-%, bezogen auf ihre nichtflüchtigen Bestandteile, an Verbindungen der Formel I. Im allgemeinen werden 0,2 bis 2, vorzugsweise 0,5 bis 1,2 Gewichtsteile an Verbindungen der Formel I je 1 Gewichtsteil polymerisierbarer Verbindungen im Gemisch verwendet.

Die Verbindungen der Formel I enthalten im Mittel mindestens 4 Urethangruppen im Molekül. Ihre mittleren Molekulargewichte liegen im allgemeinen zwischen 500 und 8000, vorzugsweise bei 900 bis 6000. Die niedermolekularen Vertreter sind viskose Flüssigkeiten, die höhermolekularen Vertreter sind fest.

Von den Verbindungen der Formel I werden diejenigen mit n=1 bis 11 bevorzugt. Verbindungen, in denen n=5 oder grösser ist, werden vorzugsweise mit niedermolekularen polymerisierbaren Verbindungen kombiniert. Hierfür sind z. B. die aus der DE-OS 20 64 079 bekannten polymerisierbaren Diurethane aus 1 Mol Diisocyanat und 2 Molen Hydroxyalkylmethacrylat oder -acrylat sowie die aus der DE-OS 23 61 041 bekannten polymerisierbaren Tetraurethane aus 1 Mol Diol bzw. Polyätherdiol, 2 Molen Diisocyanat und 2 Molen Hydroxyalkylmethacrylat oder -acrylat geeignet.

Die Verbindungen der Formel I können als reine Verbindungen mit einem genau definierten einheitlichen Wert für n vorliegen. In der Praxis werden sie zumeist entsprechend ihrem weiter unten angegebenen Herstellungsverfahren als Homologengemische vorliegen, deren Molekulargewichte und deren Werte für n um einen mittleren Wert

verteilt sind. Wenn im Folgenden von bestimmten Werten für n oder z.B. von Tetraurethanen die Rede ist, sollen dabei stets solche mitumfasst sein, deren entsprechende Werte Mittelwerte sind und in erster Näherung dem angegebenen Wert entsprechen. Die Mittelwerte für n bzw. für die Molekulargewichte lassen sich dabei auch ohne genaue Ermittlung des Molekulargewichts des erhaltenen Produkts in für die Praxis ausreichender Genauigkeit aus der Menge der eingesetzten Reaktionsteilnehmer errechnen.

Der Diolrest X in der allgemeinen Formel I kann von einem gesättigten oder einfach ungesättigten Diol abgeleitet sein. Als gesättigte Diole sind lineare und verzweigte Verbindungen mit 2 bis 12 Kohlenstoffatomen, vorzugsweise 4 bis 12 Kohlenstoffatomen, geeignet.

Beispiele für geeignete Diole sind Äthylenglykol, Propylenglykol, Butandiol-(1,4), But-2-endiol-(1,4), 2-Äthyl-hexandiol-(1,6), Decandiol-(1,10) und 1,4-Bis-hydroxymethyl-cyclohexan.

Der Diolrest X kann ferner in seiner Kette Sauerstoff- oder Schwefelatome enthalten. Bevorzugt werden Reste von Polyglykolen, insbesondere Polyäthylenglykolen, mit 1 bis 3 Ätherbindungen. Triäthylenglykole werden als Diolkomponente besonders bevorzugt.

Die Gruppe Y, die sich von dem zur Herstellung verwendeten Diisocyanat ableitet, ist eine gesättigte aliphatische oder cycloaliphatische Gruppe mit 2 bis 12, vorzugsweise 6 bis 12 Kohlenstoffatomen. Bevorzugt werden acyclische aliphatische Diisocyanate, insbesondere solche mit mindestens einer seitenständigen Methylgruppe. Dabei ist das 2,2,4-Trimethyl-hexamethylendiisocyanat ein besonders bevorzugter Vertreter.

$R_1$ ist vorzugsweise ein Rest $R_4$, $R_3$ ebenso wie $R_2$ bevorzugt ein Wasserstoffatom.

Die Herstellung der Polyurethane mit gesättigten Endgruppen erfolgt normalerweise in zwei Stufen. Zuerst wird die Diolkomponente HO-X-OH mit der gewünschten Menge an Diisocyanat OCN-Y-NCO umgesetzt. Wenn man 3 Mole Diisocyanat mit 2 Molen Diol umsetzt, so erhält man ein Zwischenprodukt mit 2 endständigen Isocyanatgruppen, das im Mittel 3 Diisocyanat- und 2 Dioleinheiten enthält, also eine Verbindung mit $n = 2$. Die endständigen Isocyanatgruppen werden dann mit dem gewünschten Alkohol oder Ätheralkohol umgesetzt. Bei diesem Verfahren werden in der Regel polymerhomologe Gemische erhalten, d.h. Gemische von Verbindungen mit unterschiedlichem n. Das gilt insbesondere bei den Vertretern mit höheren mittleren Werten für n. Diese Gemische sind für die Zwecke der Erfindung hervorragend geeignet und können unmittelbar eingesetzt werden. Wenn man Produkte mit genauer definiertem oder zumindest weniger streuendem Molekulargewicht erhalten will, kann man das genannte Diisocyanat-Zwischenprodukt auch stufenweise durch Umsetzen von 1 Mol Diol mit 2 Molen Diisocyanat, Umsetzen des Reaktionsprodukts mit 2 Molen Diol usw. herstellen. Die Zwischenprodukte mit 2 endständigen Hydroxygruppen werden in analoger Weise durch Umsetzen von Diisocyanat mit dem gewünschten Überschuss an Diol hergestellt. Die endständigen OH-Gruppen werden dann mit einem geeigneten Monoisocyanat umgesetzt.

Die erfindungsgemässen Gemische ergeben photopolymerisierbare Schichten mit hoher Lichtempfindlichkeit, hoher Flexibilität, aber geringer oder keiner Neigung zum Kaltfluss. Die Belichtungsprodukte zeichnen sich durch hohe Flexibilität und Resistenz gegen wässrig-alkalische Entwicklerlösungen sowie gegenüber Ätzlösungen und galvanischen Bädern aus. Sie weisen im übrigen alle Vorzüge der bekannten Gemische auf der Basis von alkalilöslichen Bindemitteln und Urethangruppen enthaltenden Monomeren auf. Es ist besonders überraschend, dass es durch Zusatz der nicht polymerisierbaren Polyurethane möglich ist, im Vergleich zu Schichten, die nur die bekannten polymerisierbaren Urethane enthalten, sowohl den Kaltfluss der unbelichteten Schicht zu verringern als auch die Flexibilität der Belichtungsprodukte zu erhöhen. Die gewünschte Kombination von schwer miteinander zu vereinbarenden Eigenschaften bleibt auch bei erheblicher Überbelichtung der Schicht erhalten, so dass dem Verbraucher die kostspielige und mühsame Aufgabe erspart bleibt, für jede Vorlage und Belichtung die optimale Belichtungszeit genau zu ermitteln.

Die erfindungsgemässen photopolymerisierbaren Gemische enthalten ferner polymere, vorzugsweise thermoplastische, in wässrig-alkalischen Lösungen lösliche oder mindestens quellbare Bindemittel. Derartige Polymere enthalten Gruppen, die im alkalischen Medium Salze bilden, z.B. COOH, $PO_3H_2$, $SO_3NH_2$, $SO_2NHCO$ oder OH-Gruppen. Bevorzugt werden Polymere mit Carboxylgruppen. Geeignete Bindemittel sind Maleinatharze, Polymerisate aus N-(p-Toluolsulfonyl)-carbaminsäure-(β-methacryloyloxy)-äthylester und Mischpolymerisate derartiger Monomerer, Styrol-Maleinsäureanhydrid-Mischpolymerisate und insbesondere Mischpolymerisate von Acryl- und Methacrylsäure. Die letzteren können als Comonomere Alkylacrylate und -methacrylate, wovon mindestens ein Teil Alkylgruppen mit 4 bis 15 C-Atomen hat, und zusätzlich zu diesen Styrol, ein substituiertes Styrol, Acrylnitril, Benzylacrylat oder ein ähnliches Monomeres enthalten, das ein Homopolymerisat mit einer Glastemperatur Tg von mindestens 80° C bildet. Derartige bevorzugte Bindemittel sind in den US-PS 3804631 und 3930865 beschrieben. Das Bindemittel soll ein mittleres Molekulargewicht von mindestens 10000, vorzugsweise von etwa 20000 bis 200000 haben. Die Säurezahl beträgt im allgemeinen 50 bis 250, vorzugsweise 100 bis 200. Besonders bevorzugt werden Terpolymerisate aus Methacrylsäure, einem Alkylmethacrylat mit 4 bis 12 C-Atomen im Alkylrest und Styrol oder einem substituierten Styrol. Die Menge der Bindemittel beträgt im allgemeinen 20–80, bevorzugt 35–65 Gew.-% der nichtflüchtigen Bestandteile des Gemischs.

Die erfindungsgemässen Gemische können ferner mit Vorteil bestimmte Weichmacher enthalten, die die Flexibilität der Schichten nach der Belichtung zusätzlich wesentlich verbessern. Diese Weichmacher sind im einzelnen in der gleichzeitig eingereichten europäischen Patentanmeldung 79/101411.1 (Veröffentlichungsnummer 0006125) beschrieben. Sie sind Verbindungen der Formel II

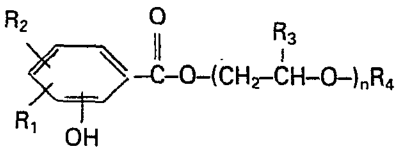

(II)

worin

$R_1$ ein Wasserstoff- oder Halogenatom oder ein Alkylrest mit 1 bis 4 Kohlenstoffatomen,

$R_2$ ein Wasserstoffatom, eine OH-Gruppe oder ein Alkylrest mit 1 bis 4 Kohlenstoffatomen,

$R_3$ ein Wasserstoffatom oder eine Methylgruppe,

$R_4$ einen Alkyl- oder Alkenylrest mit 1 bis 20 C-Atomen und

n Null oder eine Zahl von 1 bis 20, bevorzugt 1 bis 4, bedeutet,

wobei $R_4$ mindestens 4 C-Atome hat, wenn n Null oder 1 ist.

Die Weichmacher werden im allgemeinen in einer Menge bis zu 30, vorzugsweise von 10 bis 25 Gew.-%, bezogen auf die Menge der nichtflüchtigen Bestandteile des Gemischs, zugesetzt.

Die erfindungsgemässen Gemische enthalten ferner polymerisierbare Verbindungen mit mindestens zwei Acryl- oder Methacrylsäureestergruppen im Molekül. Derartige Verbindungen sind in grosser Zahl bekannt und für die Herstellung photopolymerisierbarer Gemische gebräuchlich. Beispiele sind Äthylenglykoldiacrylat, Di-, Tri- und Polyäthylenglykoldiacrylat, Hexandiol-(1,6)-diacrylat, Trimethylolpropantriacrylat, Trimethyloläthandiacrylat, Pentaerythrittriacrylat, Neopentylglykoldiacrylat, Diglycerindiacrylat sowie die entsprechenden Methacrylate. In Kombination mit den Estern können auch Amide der Acryl- und Methacrylsäure verwendet werden, z.B. Methylenbis-acrylamid, Hexamethylenbis-acrylamid oder Xylylen-bis-methacrylamid. Bevorzugt werden Acryl- und Methacrylsäureester, die im Molekül mindestens zwei Urethangruppen enthalten, da diese Monomeren Belichtungsprodukte mit guter Flexibilität und Haftung auf Metallen ergeben. Diese Verbindungen können auch Biuret- und ggf. Carbonsäureamidgruppen enthalten. Derartige Verbindungen sind in den DE-OS 2064079 und 2361041 sowie der US-PS 3850770 beschrieben. Beispiele sind Reaktionsprodukte von 2 Molen Hydroxyalkylacrylat oder -methacrylat mit 1 Mol Diisocyanat, z.B. Hexamethylendiisocyanat, 2,2,4-Trimethyl-hexamethylendiisocyanat, Isophorondiisocyanat, Dicyclohexylmethandiisocyanat und Tolylendiisocyanat. Aliphatische und cycloaliphatische Diisocyanate mit 2 bis 12 C-Atomen werden generell bevorzugt, von diesen wiederum solche mit mindestens einer seitenständigen Methylgruppe. Mit Vorteil werden ferner Monomere verwendet, die noch mindestens eine Oxyalkyleneinheit, besonders Oxyäthyleneinheiten, im Molekül enthalten. Beispiele sind die Reaktionsprodukte von Hydroxygruppen enthaltenden Acrylaten und Methacrylaten mit Diisocyanaten, die durch partielles Umsetzen einfacher Diisocyanate, wie sie oben genannt wurden, mit Diolen, z.B. Hexandiol, Diäthylenglykol, Triäthylenglykol, Pentaäthylenglykol, Tripropylenglykol und dgl. erhalten worden sind. Diese Verbindungen mit endständigen Isocyanatgruppen können eine oder mehrere Diol- bzw. Polyäthergruppen enthalten.

Besonders bevorzugt werden polymerisierbare Verbindungen, die durch Umsetzen der genannten bevorzugten Diisocyanate mit Di-, Tri- oder Tetraäthylenglykol im Molverhältnis 2:1 bis 1,1:1 und Umsetzen des Reaktionsprodukts mit 1 Mol 2-Hydroxyäthylmethacrylat je 1 Äquivalent Isocyanatgruppen erhalten werden.

Bei der bevorzugten Anwendung der Gemische zur Herstellung von Trockenresistfolien werden generell die Methacrylate bevorzugt. Besonders bevorzugt werden polymerisierbare Verbindungen mit zwei endständigen polymerisierbaren Doppelbindungen. Die Monomeren werden im allgemeinen in einer Menge von 10 bis 50 Gew.-%, vorzugsweise 15 bis 40 Gew.-%, bezogen auf die nichtflüchtigen Bestandteile des Gemisches, eingesetzt.

Als Photoinitiatoren können eine Vielzahl von Substanzen Verwendung finden. Beispiele sind Benzoin, Benzoinäther, Mehrkernchinone, z.B. 2-Äthyl-anthrachinon, Acridinderivate, z.B. 9-Phenyl-acridin, 9-p-Methoxyphenyl-acridin, 9-Acetylamino-acridin, Benz(a)acridin, Phenazinderivate, z.B. 9,10-Dimethyl-benz(a)-phenazin, 9-Methylbenz(a)phenazin, 10-Methoxy-benz(a)phenazin, Chinoxalinderivate, z.B. 6,4',4"-Trimethoxy-2,3-diphenyl-chinoxalin, 4',4"-Dimethoxy-2,3-diphenyl-5-aza-chinoxalin, Chinazolinderivate und dergl. mehr. Ihre Menge beträgt im allgemeinen 0,1 bis 10 Gew.-% der nichtflüchtigen Bestandteile des Gemisches.

Das erfindungsgemässe Gemisch kann ausser Urethanen der Formel I, polymerisierbaren Verbindungen, Photoinitiatoren, Bindemitteln und ggf. Weichmachern noch eine Reihe weiterer üblicher Zusätze enthalten, z.B. Inhibitoren zur Verhinderung der thermischen Polymerisation der Monomeren, Haftvermittler, Wasserstoffdonatoren, sensitometrische Regler, Farbstoffe, Farbpigmente, ungefärbte Pigmente, Farbbildner und Indikatoren.

Diese Bestandteile sind zweckmässig so auszuwählen, dass sie in dem für den Initiierungsvorgang wichtigen aktinischen Wellenlängenbereich möglichst nicht zu stark absorbieren.

Das erfindungsgemässe photopolymerisierbare Gemisch kann in bekannter Weise als Lösung oder Dispersion in den Handel gebracht werden, die vom Verbraucher insbesondere zur Herstellung von Ätzschutzschichten verwendet wird. Ein bevorzugtes Anwendungsgebiet für die erfindungsgemässen Gemische sind Trockenresistfolien, die aus einer auf einem temporären Träger, z.B. einer transparenten Kunststoffolie, befindlichen fertigen Photoresistschicht bestehen und die vom Verbraucher auf die bildmässig zu ätzende oder zu galvanisierende Unterlage kaschiert werden und dort belichtet und entwickelt werden, wobei vor dem Entwickeln der temporäre Träger entfernt wird.

Das erfindungsgemässe Gemisch eignet sich besonders gut für diese Anwendungsform. Es kann aber auch in Form eines vorsensibilisierten Kopiermaterials auf einem geeigneten Träger, z.B. auf Aluminium oder Zink, für die photomechanische Herstellung von Offset- oder Hochdruckformen fabrikmässig hergestellt werden. Es ist ferner zur Herstellung von Reliefbildern, Siebdruckschablonen, Farbprüffolien und dergl. geeignet. Seine Vorteile kommen in allen den Fällen zur Geltung, wo es auf gute und dauerhafte Flexibilität der belichteten Schicht bei geringem Kaltfluss der unbelichteten Schicht sowie hohe Resistenz der belichteten Schicht gegen aggressive Chemikalien ankommt.

Die Herstellung der lichtempfindlichen Materialien unter Verwendung des erfindungsgemässen Gemisches erfolgt in bekannter Weise. So kann man die Mischung in einem Lösungsmittel aufnehmen und die Lösung bzw. Dispersion durch Giessen, Sprühen, Tauchen, Antragen mit Walzen usw. auf den vorgesehenen Träger als Film aufbringen und anschliessend trocknen. Dicke Schichten (z.B. von 250 µm und darüber) kann man auch durch Extrudieren oder Verpressen als selbsttragende Folie herstellen, welche dann auf den Träger laminiert wird.

Als Träger für die zu Kopierschichten verarbeiteten Gemische kommen Metalle, z.B. Aluminium, Zink, Kupfer, Stahl, Chrom, Messing und andere Metallegierungen; Siebdruckschablonenträger, z.B. aus Nickel oder Perlongaze; und Kunststoffolien in Frage, wobei die Kunststoffolien, z.B. Polyesterfolien, speziell oberflächenbehandelt sein können.

Die Kopierschichten werden in bekannter Weise belichtet und entwickelt. Als Entwickler sind wässrige, vorzugsweise wässrigalkalische Lösungen, z.B. von Alkaliphosphaten oder Alkalisilikaten, geeignet, denen gegebenenfalls kleine Mengen, z.B. bis zu 10, vorzugsweise weniger als 5, Gew.-% an wassermischbaren organischen Lösungsmitteln oder auch Netzmittel zugesetzt werden können. Die Entwicklung kann von Hand oder in handelsüblichen Sprüh- oder Bürstenwicklungsgeräten erfolgen.

Die erfindungsgemässen Gemische lassen sich, wie oben erwähnt, für die verschiedensten Anwendungsgebiete einsetzen. Mit besonderem Vorteil werden sie zur Herstellung von Photoresist- bzw. Ätzschutzschichten auf metallischen Trägern verwendet. Vor allem sind sie zur Anwendung auf Trägern aus Kupfer geeignet. Die ausgezeichnete Haftung und Flexibilität der belichteten Schichtteile bewährt sich bei diesen bevorzugten Anwendungsformen nicht nur während der Entwicklung, sondern auch während einer nachfolgenden Ätzung des Trägers, bei der die Schichten eine gute Flexibilität und Ätzresistenz zeigen.

Die Gemische lassen sich besonders gut in der Form sogenannter Trockenresistmaterialien, wie sie oben erwähnt wurden, einsetzen und handhaben, da sie sich auch trocken zu gut haftenden Schichten auf Metallträger übertragen lassen. In diesem Fall sind als temporäre Trägerfolien besonders Polyesterfolien geeignet.

Die folgenden Beispiele erläutern einzelne Ausführungsformen des erfindungsgemässen Gemischs. Wenn nichts anderes angegeben ist, sind Prozentzahlen und Mengenverhältnisse in Gewichtseinheiten zu verstehen.

Beispiel 1

Eine Lösung aus:

| | |
|---|---|
| 6,5 g | eines Terpolymerisats aus n-Hexylmethacrylat, Methacrylsäure und Styrol (60:30:10 Gew.-Teile) mit einem mittleren Molgewicht von ca. 35000, |
| 2,8 g | des unten angegebenen gesättigten Polyurethans, |
| 2,8 g | eines polymerisierbaren Polyurethans, das durch Umsetzung von 2 Molen 2,2,4-Trimethyl-hexamethylendiisocyanat mit 1 Mol wasserfreiem Triäthylenglykol und weitere Umsetzung des Reaktionsprodukts mit 2 Molen Hydroxyäthyl-methacrylat hergestellt wurde, |
| 2,8 g | 4-Hydroxy-(2-äthyl-hexyl)benzoat, |
| 0,2 g | 9-Phenyl-acridin, |
| 0,1 g | 3-Mercapto-propionsäure-2,4-dichloranilid und |
| 0,025 g | des Farbstoffs «Disperse Red» (C.J. 179) in |
| 25 g | Methyläthylketon und |
| 2 g | Äthanol |

wird auf eine biaxial verstreckte und thermofixierte Polyäthylenterephthalatfolie der Stärke 25 µm so aufgeschleudert, dass nach dem Trocknen bei 100° C ein Schichtgewicht von 49 g/$m^2$ erhalten wird.

Man erhält eine Trockenresistfolie, die mit einer handelsüblichen Laminiervorrichtung bei 120° C auf eine mit 35 µm starker Kupferfolie kaschierte Phenoplast-Schichtstoffplatte laminiert und 14 Sekunden mit einem handelsüblichen Belichtungsgerät belichtet wird. Als Vorlage dient eine Strichvorlage mit Linienbreiten und Abständen bis herab zu 80 µm.

Nach der Belichtung wird die Polyesterfolie abgezogen und die Schicht in einer 0,8%igen $Na_2CO_3$-Lösung in einem Sprühentwicklungsgerät 70 Sekunden lang entwickelt.

Die Platte wird dann 30 Sekunden mit Leitungswasser gespült, 1 Minute in einer 25%igen Ammoniumperoxydisulfat-Lösung angeätzt und sodann nacheinander in den folgenden Elektrolytbädern galvanisiert:

1.) 40 Minuten in einem Kupferelektrolytbad der Firma Blasberg, Solingen, Typ «Feinkornkupferplastic-Bad»
Stromdichte: 2 A/$dm^2$
Metallaufbau: ca. 20 µm
2.) 10 Minuten in einem Nickelbad Typ «Norma» der Firma Blasberg, Solingen

Stromdichte: 4 A/$dm^2$
Metallaufbau: 6 µm
und

3.) 15 Minuten in einem Goldbad Typ «Autronex N» der Firma Blasberg, Solingen
Stromdichte: 0,6 A/$dm^2$
Metallaufbau: 2,5 µm

Die Platte zeigt keinerlei Unterwanderungen oder Beschädigungen.

Die Platte kann sodann in 5%iger KOH-Lösung bei 50° C entschichtet und das freigelegte Kupfer in den üblichen Ätzmedien weggeätzt werden.

Die oben beschriebene Trockenresistfolie ist auch bei 11-facher Überbelichtung, also noch nach 160 Sekunden Belichtungszeit mit dem oben beschriebenen Belichtungsgerät völlig flexibel. Dies kann man zeigen, wenn man einen etwa 2cm breiten und 20cm langen Streifen aus Trägerfolie und Schicht im belichteten Zustand mit der Hand dehnt. Hierbei lässt sich der 11-fach überbelichtete Trockenresiststreifen ohne Platzen oder Reissen der Schicht auf mindestens das Doppelte der Länge bei Zimmertemperatur verstrecken.

Diese Flexibilität ist in vielen Verarbeitungsschritten, wie Beschneiden nach dem Laminieren, Ätzen und Galvanisieren in Goldbädern u.a. von ausschlaggebendem Vorteil. Die oben beschriebene Trockenresistfolie hat ferner einen sehr geringen Kaltfluss im unbelichteten Zustand, der das Lagern von Rollen auch über lange Zeit ohne Ausquellen der Resistschicht an den Rändern ermöglicht.

Die oben beschriebene Schicht erlaubt Linien der Breite 50µm kantenscharf aufzulösen, dies kann leicht durch Belichtung durch eine Auflösungstestvorlage und Entwicklung mit 0,8%iger $Na_2CO_3$-Lösung nachgewiesen werden. Die Entwicklerresistenz beträgt mindestens das Dreifache der Entwicklungszeit.

Synthese des Polyurethans

In einem Dreihalskolben mit Rührer, Rückflusskühler mit aufgesetztem $CaCl_2$-Trockenrohr und Tropftrichter werden 2 Mole 2,2,4-Trimethyl-hexamethylendiisocyanat in 800g Methyläthylketon vorgelegt. Nach Zugabe einer als Katalysator wirkenden Mischung aus

1,5 gEisen(III)acetylacetonat und
2,0 gDiäthylcyclohexylamin in
50,0 gMethyläthylketon

wird 1 Mol wasserfreies Triäthylenglykol, gelöst in 50g Methyläthylketon so zudosiert, dass die Reaktionstemperatur konstant auf 70 ± 1° C gehalten wird. Hierzu wird von aussen durch ein Wasserbad, das zunächst eine Temperatur von 60° C hat, erwärmt und – nach Erreichung der gewünschten Innentemperatur durch die Reaktionswärme der Polyadditionsreaktion – gekühlt (Badtemperatur: ca. 40 bis 50° C). Nach Ende der Zugabe des Triäthylenglykols werden 2 Mole Triäthylenglykolmonobutyläther bei 70° C zugetropft. Nach Ende der Reaktion wird noch 2 Std. bei 70° C gerührt, dann wird die Lösung abgekühlt. Das so erhaltene Polyurethan kann in Lösung oder nach Abdestillieren des Lösungsmittels als Harz in den photomerisierbaren Gemischen verwendet werden; in den Beispielen wurden die Polyurethane jeweils als Harz eingesetzt.

Beispiel 2

Statt des in Beispiel 1 beschriebenen gesättigten Polyurethans kann auch in gleicher Menge (2,8g) ein Polyurethan verwendet werden, das in analoger Weise aus
4 Molen 2,2,4-Trimethyl-hexamethylendiisocyanat und
3 Molen Triäthylenglykol (1. Reaktionsstufe) und danach
2 Molen Triäthylenglykolmonobutyläther (2. Reaktionsstufe)
hergestellt wurde.

Nach analoger Verarbeitung zu einer Trockenresistfolie mit einem Schichtgewicht von 53g/$m^2$ wird eine auch bei 10-facher Überbelichtung noch dehnbare und flexible Resistschicht erhalten. Die Galvanoresistenzen in den in Beispiel 1 angegebenen Elektrolytbädern sind ausgezeichnet.

Beispiel 3

Statt des in Beispiel 1 angegebenen gesättigten Polyurethans kann auch in gleicher Menge (2,8g) ein Polyurethan verwendet werden, das analog der Synthesevorschrift in Beispiel 1 aus
2 Molen 2,2,4-Trimethyl-hexamethylendiisocyanat und
1 Mol Buten-(2)-diol-(1,4) (1. Reaktionsstufe) und danach
2 Molen Diäthylenglykol-mono-2-äthylhexyläther (2. Reaktionsstufe)
synthetisiert wurde.

Schichtgewicht der hieraus hergestellten

| | |
|---|---|
| Trockenresistfolie: | 51 g/$m^2$ |
| Belichtungszeit: | 16 Sekunden |
| Entwicklung: | 80 Sekunden mit 0,8% $Na_2CO_3$ |
| Testergebnisse: | analog Beispiel 1 |

Beispiel 4

Statt des in Beispiel 1 angegebenen gesättigten Polyurethans kann in gleicher Menge ein Polyurethan verwendet werden, das aus
2 Molen 2,2,4-Trimethyl-hexamethylendiisocyanat und
1 Mol Thiodiäthylenglykol (1. Reaktionsstufe) und danach
2 Molen Diäthylenglykol-mono-2-äthylhexyläther (2. Reaktionsstufe)
synthetisiert wurde.

Die Testergebnisse der hiernach hergestellten Trockenresistfolie mit dem Schicht 53g/$m^2$ waren ähnlich wie in Beispiel 1.

Beispiel 5

Statt des in Beispiel 1 angegebenen gesättigten Polyurethans kann auch in gleicher Menge ein Polyurethan verwendet werden, das aus
2 Molen Triäthylenglykol (Vorlage) und
1 Mol 2,2,4,-Trimethyl-hexamethylendiisocyanat (1. Reaktionsstufe) und danach
2 Molen Octadecylmonoisocyanat (2. Reaktionsstufe)

synthetisiert wurde. Es wurde eine Trockenresistfolie mit dem Schichtgewicht 53 g/m$^2$ hergestellt. Die Testergebnisse sind ähnlich gut wie die in Beispiel 1 angegebenen.

Beispiel 6

Eine Lösung aus

6,5 g des in Beispiel 1 angegebenen Terpolymerisats,
2,8 g eines polymerisierbaren Diurethans, das aus 1 Mol 2,2,4-Trimethyl-hexamethylendiisocyanat und 2 Molen Hydroxyäthylmethylacrylat hergestellt wurde,
2,8 g des 4-Hydroxy-benzoesäureesters des Diäthylenglykolmono-n-hexyläthers,
0,2 g 9-Phenyl-acridin,
0,1 g 3-Mercapto-propionsäure-2,4-dichloranilid,
0,025 g des in Beispiel 1 angegebenen Farbstoffs,
2,8 g eines gesättigten Polyurethans, das analog der in Beispiel 1 angegebenen Synthesevorschrift aus
11 Molen 2,2,4-Trimethyl-hexamethylendiisocyanat und
10 Molen Triäthylenglykol (1. Reaktionsstufe) und danach
2 Molen Diäthylenglykol-mono-2-äthylhexyläther (2. Reaktionsstufe)
synthetisiert wurde, in
-35 g Methyläthylketon und
2 g Äthanol

wird wie in Beispiel 1 zu einer Trockenresistfolie verarbeitet, so dass auf der Polyesterfolie nach dem Trocknen ein Schichtgewicht von 52 g/m$^2$ erhalten wird.

Die Prüfung dieser Trockenresistfolie wie in Beispiel 1 ergibt ähnlich gute Eigenschaften hinsichtlich Galvanoresistenz und Flexibilität der belichteten und 10-fach überbelichteten Resistschicht.

Beispiel 7

Statt des angegebenen gesättigten Polyurethans kann man in Beispiel 6 auch die gleiche Menge (2,8g) eines Polyurethans verwenden, das analog aus
2 Molen 2,2,4-Trimethyl-hexamethylendiisocyanat und
1 Mol Butandiol-(1,4) (1. Reaktionsstufe) und danach
2 Molen Triäthylenglykolmonobutyläther (2. Reaktionsstufe)
synthetisiert wurde.

Die Ergebnisse mit der erhaltenen Trockenresistfolie vom Schichtgewicht 52 g/m$^2$ sind mit denen von Beispiel 6 vergleichbar. Die Flexibilität der 6-fach überbelichteten Resistschicht ist noch gut, so dass beim Dehnen eines Messstreifens noch kein Reissen oder Splittern der Schicht auftritt.

Beispiel 8

Eine Lösung aus

6,5 g des in Beispiel 1 angegebenen Terpolymerisats,
2,8 g des in Beispiel 1 angegebenen polymerisierbaren Polyurethans,
2,8 g 4-Hydroxy-(2-äthylhexyl)-benzoat,
0,1 g 3-Mercapto-propionsäure-2,4-dichloranilid,
0,2 g 9-Phenyl-acridin,
0,025 g des in Beispiel 1 angegebenen Farbstoffs,
2,8 g eines gesättigten Polyurethans, das durch Umsetzen von 2 Molen 2,2,4-Trimethyl-hexamethylendiisocyanat mit 1 Mol Triäthylenglykol (1. Reaktionsstufe) und Umsetzen des Reaktionsprodukts mit 2 Molen Diäthylenglykol-mono-2-äthylhexyläther (2. Reaktionsstufe) erhalten wurde, in
25 g Methyläthylketon und
2 g Äthanol

wurde wie in Beispiel 1 beschrieben zu einer Trokkenresistfolie vom Schichtgewicht 52 g/m$^2$ verarbeitet.

Die Prüfung ergibt nach dem Laminieren, Belichten (15 Sekunden) und 100 Sekunden Entwikkeln in 0,8%iger $Na_2CO_3$-Lösung eine Resistmaske von ausgezeichneter Resistenz in den in Beispiel 1 angegebenen Galvanobädern. Die Flexibilität der 11-fach überbelichteten Resistfolie (160 Sekunden Belichtungszeit) ist noch ausgezeichnet.

Beispiel 9 (Vergleichsbeispiel)

Verwendet man statt der in Beispiel 6 angegebenen Mischung aus
2,8 g des polymerisierbaren Diurethans und
2,8 g des gesättigten Polyurethans
nur
5,6 g des polymerisierbaren Diurethans,
dann erhält man bei sonst gleicher Schichtzusammensetzung, einem Schichtgewicht von 52 g/m$^2$ eine Trockenresistschicht, die etwa die gleiche Lichtempfindlichkeit besitzt, jedoch beim Überbelichten wesentlich stärker zum Verspröden neigt. So ist die Schicht bei einfacher Belichtungszeit noch flexibel; bei doppelter Belichtungszeit, also bei etwa 30 Sekunden und zunehmend ab 40 Sekunden Belichtungszeit mit dem in Beispiel 1 angegebenen Belichtungsgerät wird die Schicht jedoch spröde und lässt sich nicht mehr dehnen, ohne zu reissen und zu splittern. Darüber hinaus neigt diese Schicht wesentlich stärker zum Fliessen bei Zimmertemperatur und damit zu störendem Randaustritt bei Trockenresistrollen, z.B. mit einer Wickellänge von 50 m, als die Schicht von Beispiel 6. Die Schicht gemäss Beispiel 6 zeigt keinen störenden Randaustritt der Resistrollen beim Lagern, was auf den wesentlich geringeren Kaltfluss zurückgeführt werden kann.

## Patentansprüche

1. Photopolymerisierbares Gemisch, enthaltend ein polymeres, in wässrig-alkalischen Lösungen lösliches oder quellbares Bindemittel, einen Photoinitiator und eine zur Additionspolymerisation befähigte Verbindung mit mindestens zwei endständigen Acryl- oder Methacrylsäureestergruppen und einem Siedepunkt oberhalb 100° C, dadurch gekennzeichnet, dass das Gemisch zusätzlich ein Polyurethan der Formel I

$$\begin{array}{l} Y\text{–}(NHCOO\text{–}X\text{–}CONH\text{–}Y\text{–})_nNHCOO\text{–}Z\text{–}R_1 \\ | \\ NH \\ | \\ COO\text{–}Z\text{–}R_1 \end{array} \qquad (I)$$

enthält, worin

X eine der Gruppen

$$\begin{array}{l} (\text{–}CH_2\text{–}\underset{\displaystyle R_2}{\underset{|}{C}}H\text{–}O)_m\text{–} \end{array} ,$$

$$(\text{–}CH_2\text{–}\underset{\displaystyle R_2}{\underset{|}{C}}H\text{–}S\text{–})_{m-1}CH_2\underset{\displaystyle R_2}{\underset{|}{C}}H\text{–}O\text{–} ,$$

$$\text{–}C_kH_{2k}\text{–}O\text{–} \quad \text{und}$$

$$\text{–}C_rH_{2r-2}\text{–}O\text{–}$$

Y ein gesättigter aliphatischer oder cycloaliphatischer Rest mit 2 bis 12 Kohlenstoffatomen,

Z $(\text{–}CH_2\text{–}\underset{\displaystyle R_3}{\underset{|}{C}}H\text{–}O)_p$ ,

$R_1$ $R_4$ oder CONH-$R_4$,

$R_2$ und $R_3$ Wasserstoffatome oder Methylgruppen,

$R_4$ ein gesättigter aliphatischer Rest mit 1 bis 20 Kohlenstoffatomen,

n Null oder eine Zahl von 1 bis 15,

m eine Zahl von 2 bis 4,

p Null oder eine Zahl von 1 bis 4,

k eine Zahl von 2 bis 12,

r eine Zahl von 4 bis 12 und

n + p eine Zahl von 1 bis 19

ist, wobei $R_1$ $R_4$ bedeutet, wenn p=0 ist, und $R_1$ CONH-$R_4$ bedeutet, wenn n=0 ist.

2. Photopolymerisierbares Gemisch nach Anspruch 1, dadurch gekennzeichnet, dass es eine Verbindung der Formel I enthält, worin n eine Zahl von 1 bis 11 ist.

3. Photopolymerisierbares Gemisch nach Anspruch 1, dadurch gekennzeichnet, dass es eine Verbindung der Formel I enthält, worin X die Gruppe

$$(\text{–}CH_2\text{–}\underset{\displaystyle R_2}{\underset{|}{C}}H\text{–}O)_m\text{–}$$

bedeutet.

4. Photopolymerisierbares Gemisch nach Anspruch 3, dadurch gekennzeichnet, dass es eine Verbindung der Formel I enthält, worin $R_2$ ein Wasserstoffatom ist.

5. Photopolymerisierbares Gemisch nach Anspruch 4, dadurch gekennzeichnet, dass es eine Verbindung der Formel I enthält, worin m=3 ist.

6. Photopolymerisierbares Gemisch nach Anspruch 1, dadurch gekennzeichnet, dass es eine Verbindung der Formel I enthält, worin $R_3$ ein Wasserstoffatom ist.

7. Photopolymerisierbares Gemisch nach Anspruch 1, dadurch gekennzeichnet, dass es eine Verbindung der Formel I enthält, worin Y ein gesättigter aliphatischer Rest mit mindestens einer seitenständigen Methylgruppe ist.

8. Photopolymerisierbares Gemisch nach Anspruch 1, dadurch gekennzeichnet, dass es 5 bis 40 Gew.-%, bezogen auf seine nichtflüchtigen Bestandteile, an Verbindungen der Formel I enthält.

9. Photopolymerisierbares Gemisch nach Anspruch 1, dadurch gekennzeichnet, dass die zur Additionspolymerisation befähigte Verbindung mindestens zwei Urethangruppen im Molekül aufweist.

10. Photopolymerisierbares Gemisch nach Anspruch 1, dadurch gekennzeichnet, dass das Bindemittel ein Mischpolymerisat der Acryl- oder Methacrylsäure mit einer Säurezahl von 50 bis 250 ist.

11. Photopolymerisierbares Gemisch nach Anspruch 10, dadurch gekennzeichnet, dass das Mischpolymerisat ein Terpolymerisat aus Methacrylsäure, einem Alkylmethacrylat mit 4 bis 15 C-Atomen in der Alkylgruppe und einem weiteren, damit mischpolymerisierbaren Monomeren ist, dessen zugehöriges Homopolymerisat eine Glastemperatur von mindestens 80° C aufweist.

12. Lichtempfindliches Schichtübertragungsmaterial aus einem temporären flexiblen Schichtträger, einer thermoplastischen photopolymerisierbaren Schicht, die ein polymeres, thermoplastisches, in wässrig-alkalischen Lösungen lösliches oder quellbares Bindemittel, einen Photoinitiator und eine zur Additionspolymerisation befähigte Verbindung mit mindestens zwei endständigen Acryl- oder Methacrylsäureestergruppen und einem Siedepunkt oberhalb 100° C enthält, und gegebenenfalls einem abziehbaren Deckblatt auf der dem Schichtträger abgewandten Seite der Schicht, dadurch gekennzeichnet, dass die Schicht zusätzlich ein Polyurethan der Formel I

$$\begin{array}{l} Y\text{–}(NHCOO\text{–}X\text{–}CONH\text{–}Y\text{–})_nNHCOO\text{–}Z\text{–}R_1 \\ | \\ NH \\ | \\ COO\text{–}Z\text{–}R_1 \end{array} \qquad (I)$$

enthält, worin

X eine der Gruppen

$$(\text{–}CH_2\text{–}\underset{\displaystyle R_2}{\underset{|}{C}}H\text{–}O)_m\text{–} ,$$

$$(\text{–}CH_2\text{–}\underset{\displaystyle R_2}{\underset{|}{C}}H\text{–}S\text{–})_{m-1}CH_2\underset{\displaystyle R_2}{\underset{|}{C}}H\text{–}O\text{–}$$

$$\text{–}C_kH_{2k}\text{–}O\text{–} \quad \text{und}$$

$$\text{–}C_rH_{2r-2}\text{–}O\text{–}$$

Y ein gesättigter aliphatischer oder cycloaliphatischer Rest mit 2 bis 12 Kohlenstoffatomen,

Z $(-CH_2-CH-O)_p$ ,
|
$R_3$

$R_1$ $R_4$ oder CONH-$R_4$,
$R_2$ und $R_3$ Wasserstoffatome oder Methylgruppen,
$R_4$ ein gesättigter aliphatischer Rest mit 1 bis 20 Kohlenstoffatomen,
n Null oder eine Zahl von 1 bis 15,
m eine Zahl von 2 bis 4,
p Null oder eine Zahl von 1 bis 4,
k eine Zahl von 2 bis 12,
r eine Zahl von 4 bis 12 und
n + p eine Zahl von 1 bis 19
ist, wobei $R_1$ $R_4$ bedeutet, wenn p=0 ist, und $R_1$ CONH-$R_4$ bedeutet, wenn n=0 ist.

**Claims**

1. Photopolymerizable mixture comprising a polymeric binder which is soluble or swellable in aqueous alkaline solutions, a photo-initiator, and a compound with at least two terminal acrylic or methacrylic acid ester groups and a boiling point above 100° C which is capable of addition polymerization, characterized in that the mixture additionally contains a polyurethane corresponding to the following Formula I

$Y-(NHCOO-X-CONH-Y-)_nNHCOO-Z-R_1$ (I)
|
NH
|
$COO-Z-R_1$

wherein
X is one of the following groups:

$(-CH_2-CH-O)_m-$
|
$R_2$

$(-CH_2-CH-S-)_{m-1}CH_2CH-O-$ ,
| |
$R_2$ $R_2$

$-C_kH_{2k}-O-$ or

$-C_rH_{2r-2}-O-$

Y is a saturated aliphatic or cycloaliphatic group with 2 to 12 carbon atoms,
Z is $(-CH_2-CH-O)_p$
|
$R_3$
$R_1$ is $R_4$ or CONH-$R_4$,
$R_2$ and $R_3$ are hydrogen atoms or methyl groups,
$R_4$ is a saturated aliphatic group with 1 to 20 carbon atoms,
n is zero or a whole number from 1 to 15,
m is a whole number from 2 to 4,
p is zero or a whole number from 1 to 4,
k is a whole number from 2 to 12,
r is a whole number from 4 to 12,
n + p is a whole number from 1 to 19,
and wherein
$R_1$ is $R_4$ if p=0, and $R_1$ is CONH-$R_4$ if n=0.

2. Photopolymerizable mixture according to claim 1, characterized in that it contains a compound corresponding to Formula I wherein n is a whole number from 1 to 11.

3. Photopolymerizable mixture according to claim 1, characterized in that it contains a compound corresponding to Formula I wherein X is the group

$(-CH_2-CH-O)_m-$
|
$R_2$

4. Photopolymerizable mixture according to claim 3, characterized in that it contains a compound corresponding to Formula I wherein $R_2$ is a hydrogen atom.

5. Photopolymerizable mixture according to claim 4, characterized in that it contains a compound corresponding to Formula I wherein m=3.

6. Photopolymerizable mixture according to claim 1, characterized in that it contains a compound correspondig to Formula I wherein $R_3$ is a hydrogen atom.

7. Photopolymerizable mixture according to claim 1, characterized in that it contains a compound correspondig to Formula I wherein Y is a saturated aliphatic group with a least one lateral methyl group.

8. Photopolymerizable mixture according to claim 1, characterized in that it contains between 5 and 40 per cent by weight, based on the weight of its non-volatile components, of compounds corresponding to Formula I.

9. Photopolymerizable mixture according to claim 1, characterized in that the compound capable of addition polymerization has at least two urethane groups in its molecule.

10. Photopolymerizable mixture according to claim 1, characterized in that the binder is an acrylic or methacrylic acid copolymer with an acid number between 50 and 250.

11. Photopolymerizable mixture according to claim 10, characterized in that the copolymer is a terpolymer of methacrylic acid, an alkyl methacrylate with 4 to 15 carbon atoms in the alkyl group and a further monomer which can be copolymerized with the first two components and whose hommopolymer has a glass transition temperature of at least 80° C.

12. Leight-sensitive layer transfer material, comprising a flexible temporary support and a thermoplastic photopolymerizable layer which comprises a polymeric thermoplastic binder which is soluble or swellable in aqueous alkaline solutions a photoinitiator, and a compound with at least two terminal acrylic or methacrylic acid ester groups and a boiling point above 100° C which is capable of addition polymerization, and if desired, further comprising a peelable cover film on the surface of the layer remote from the support, characterized in that the layer additionally contains a polyurethane corresponding to the following Formula

$Y-(NHCOO-X-CONH-Y-)_nNHCOO-Z-R_1$ (I)
|
NH
|
$COO-Z-R_1$

wherein

X is one of the following groups:

$(-CH_2-CH(R_2)-O)_m-$ ,

$(-CH_2-CH(R_2)-S-)_{m-1}CH_2CH(R_2)-O-$ ,

$-C_kH_{2k}-O-$ or

$-C_rH_{2r-2}-O-$

Y is a saturated aliphatic or cycloaliphatic group with 2 to 12 carbon atoms,

Z is , $(-CH_2-CH(R_3)-O)_p$

$R_1$ is $R_4$ or $CONH-R_4$,

$R_2$ and $R_3$ are hydrogen atoms or methyl groups,

$R_4$ is a saturated aliphatic group with 1 to 20 carbon atoms,

n is zero or a whole number from 1 to 15,

m is a whole number from 2 to 4,

p is zero or a whole number from 1 to 4,

k is a whole number from 2 to 12,

r is a whole number from 4 to 12,

n + p is a whole number from 1 to 19,

and wherein

$R_1$ is $R_4$ if $p=0$, and $R_1$ is $CONH-R_4$ if $n=0$.

**Revendications**

1. Mélange photopolymérisable contenant un liant polymère soluble ou gonflable dans des solutions aqueuses alcalines, un photo-initiateur et un composé susceptible de polymériser par addition ayant au moins deux groupes d'ester acrylique ou méthacrylique en position terminale et un point d'ébullition supérieur à 100° C, caractérisé en ce que ce mélange renferme en outre un polyuréthane de formule I:

$Y-(NHCOO-X-CONH-Y-)_nNHCOO-Z-R_1$ (I)
|
NH
|
$COO-Z-R_1$

dans laquelle

X est un des groupes suivants:

$(-CH_2-CH(R_2)-O)_m-$ ,

$(-CH_2-CH(R_2)-S-)_{m-1}CH_2CH(R_2)-O-$ ,

$-C_kH_{2k}-O-$ et

$-C_rH_{2r-2}-O-$

Y est un reste aliphatique saturé ou cycloaliphatique ayant de 2 à 12 atomes de carbone

Z est $(-CH_2-CH(R_3)-O)_p$

$R_1$ est $R_4$ ou $CONH-R_4$,

$R_2$ est $R_3$ sont des atomes d'hydrogène ou des groupes méthyle

$R_4$ est un reste aliphatique saturé ayant de 1 à 20 atomes de carbone

n est égal à zéro ou à un nombre de 1 à 15,

m est un nombre de 2 à 4,

p est égal à zéro ou à un nombre de 1 à 4

k est un nombre de 2 à 12

r est un nombre de 4 à 12 et

n + p est un nombre de 1 à 19

où $R_1$ est égal à $R_4$ pour $p=0$, et $R_1$ est égal à $CONH-R_4$ pour $n=0$.

2. Mélange photopolymérisable selon la revendication 1, caractérisé en ce qu'il comprend un composé de formule I où n est un nombre de 1 à 11.

3. Mélange photopolymérisable selon la revendication 1, caractérisé en ce qu'il comprend un composé de formule I où X est le groupe

$(-CH_2-CH(R_2)-O)_m-$

4. Mélange photopolymérisable selon la revendication 3, caractérisé en ce qu'il renferme un composé de formule I où $R_2$ est un atome d'hydrogène.

5. Mélange photopolymérisable selon la revendication 4, caractérisé en ce qu'il comprend un composé de formule I où $m=3$.

6. Mélange photopolymérisable selon la revendication 1, caractérisé en ce qu'il comprend un composé de formule I où $R_3$ est un atome d'hydrogène.

7. Mélange photopolymérisable selon la revendication 1, caractérisé en ce qu'il comprend un composé de formule I où Y est un reste aliphatique saturé ayant au moins un groupe méthyle en position latérale.

8. Mélange photopolymérisable selon la revendication 1, caractérisé en ce qu'il comprend entre 5 et 40% en poids, par rapport aux ingrédients non volatils, de composés de formule I.

9. Mélange photopolymérisable selon la revendication 1, caractérisé en ce que le composé susceptible de polymériser par addition présente au moins deux groupes uréthane dans la molécule.

10. Mélange photopolymérisable selon la revendication 1, caractérisé en ce que le liant est un produit de polymérisation mixte de l'acide acrylique ou méthacrylique ayant un indice d'acide entre 50 et 250.

11. Mélange photopolymérisable selon la revendication 10, caractérisé en ce que le produit de polymérisation mixte est formé par terpolymérisation à partir d'acide méthacrylique, un méthacrylate d'alkyle ayant de 4 à 15 atomes de carbone dans le groupe alkyle et un autre monomère pouvant engager une polymérisation mixte avec les précédents, dont le produit d'homopolymérisation correspondant présente une température de transition vitreuse au moins égale à 80° C.

12. Matière de transfer de couche photosensible comprenant un support de couche provisoire flexible, une couche photopolymérisable thermoplastique, renfermant un liant polymère thermoplastique soluble ou gonflable dans des solutions aqueuses alcalines, un photo-initiateur et un composé susceptible de polymériser par addition ayant au moins deux groupes d'ester acrylique ou méthacrylique en position terminale et un point d'ébullition supérieur à 100° C, et éventuellement une feuille de couverture détachable sur le côté de la couche qui n'est pas tourné vers le support de couche, caractérisé en ce que la couche renferme en outre un polyuréthane de formule I

$$\begin{array}{l} Y\text{–}(NHCOO\text{–}X\text{–}CONH\text{–}Y\text{–})_nNHCOO\text{–}Z\text{–}R_1 \\ | \\ NH \\ | \\ COO\text{–}Z\text{–}R_1 \end{array} \qquad (I)$$

dans laquelle

X est un des groupes suivants:

$$\begin{array}{l} (\text{–}CH_2\text{–}\underset{\displaystyle R_2}{\underset{|}{C}}H\text{–}O)_m\text{–} \end{array} ,$$

$$(\text{–}CH_2\text{–}\underset{\displaystyle R_2}{\underset{|}{C}}H\text{–}S\text{–})_{m-1}CH_2\underset{\displaystyle R_2}{\underset{|}{C}}H\text{–}O\text{–} ,$$

$$\text{–}C_kH_{2k}\text{–}O\text{–} \quad \text{et}$$

$$\text{–}C_rH_{2r-2}\text{–}O\text{–}$$

Y est un reste aliphatique saturé ou cycloaliphatique ayant de 2 à 12 atomes de carbone.

Z est le groupe

$$(\text{–}CH_2\text{–}\underset{\displaystyle R_3}{\underset{|}{C}}H\text{–}O)_p ,$$

$R_1$ est $R_4$ ou CONH-$R_4$,

$R_2$ et $R_3$ sont des atomes d'hydrogène ou des groupes méthyle

$R_4$ est un reste aliphatique saturé ayant de 1 à 20 atomes de carbone

n est égal à zéro ou à un nombre de 1 à 15,

m est un nombre de 2 à 4,

p est égal à zéro ou à un nombre de 1 à 4,

k est un nombre de 2 à 12,

r est un nombre de 4 à 12 et

n + p est un nombre de 1 à 19,

où $R_1$ est $R_4$ pour $p=0$, et $R_1$ est CONH-$R_4$ pour $n=0$.